# EUROPEAN PATENT APPLICATION

(11) **EP 4 746 028 A1**
(43) Date of publication of application: **20.05.2026**
(21) Application number: 24839251.6
(22) Date of filing: 28.03.2024
(51) Int. Cl.: H01L 21/52, H01L 21/60

(54) **MOUNTING DEVICE AND MOUNTING METHOD**

(30) Priority: 10.07.2023 JP 2023112824
(71) Applicant: Yamaha Robotics Co., Ltd., Musashimurayama-shi, Tokyo 208-8585 (JP)
(72) Inventor: SAITO, Takashi, Musashimurayama-shi, Tokyo 208-8585 (JP); NOMURA, Yudai, Musashimurayama-shi, Tokyo 208-8585 (JP)
(74) Representative: Becker, Eberhard
(86) International application number: PCT/JP2024/012886
(87) International publication number: WO 2025/013353

(57) **Abstract**

A mounting device (1) comprises: a first mold (10) that is configured to hold substrates (SB1, SB2) on which electronic components (CH11, CH12, CH21, CH22) are placed; a second mold (20) having at least one movable mechanism (22A, 22B, 22C, 22D) that is connected to an internal space (23); and a pressure transmission mechanism (PR) for pressing a viscous member (23V) that is enclosed in the internal space (23) of the second mold (20), wherein, in a state in which the first mold (10) and the second mold (20) are closed, the electronic components (CH11, CH12, CH21, CH22) are pressed by the movable mechanisms (22A, 22B, 22C, 22D) with the viscous member (23V) interposed therebetween, on the basis of a pressing force with which the pressure transmission mechanism (PR) presses the viscous member (23V).

## Description

### Technical Field

The invention relates to a mounting device and a mounting method.

### Related Art

A mounting device is known that simultaneously pressurizes multiple electronic components onto at least one substrate when mounting the electronic components on the substrate via a bonding material. In such mounting device, each of the electronic components may be individually pressurized so that mounting defects do not occur due to an insufficient or excessive pressure on the electronic components resulting from the differences in dimensions among the electronic components.

For example, Patent Document 1 discloses a semiconductor mounting device that includes multiple pressing blocks for individually pressurizing multiple semiconductor elements, multiple shafts for linearly moving the pressing blocks, multiple pressure blocks for pressurizing the blocks via the shafts, and an elastic body for collectively pressurizing the pressure blocks. The pressure blocks are pressurized by supplying an air pressure or a compressed gas pressure to a pressure valve and expanding the elastic body toward the side of the pressure blocks.

### Prior Art Document(s)

### Patent Document(s)

[Patent Document 1] Japanese Patent Application Laid-Open Publication No. 2002-110744

### SUMMARY OF INVENTION

### Technical Problem

However, the semiconductor mounting device described in Patent Document 1 needs to include a compressor or a high-pressure tank for supplying the air pressure or the compressed gas pressure, and a piping for passing air or compressed gas. Therefore, the size of the device may be large.

The invention has been made in view of such circumstances, and an object thereof is to provide a compact mounting device capable of suppressing the occurrence of mounting defects and a mounting method using the same.

### Solution to Problem

An aspect of the invention provides a mounting device for mounting one or more electronic components on at least one substrate. The mounting device includes: a first mold, configured to hold the substrate on which the electronic component is placed; a second mold, disposed opposite to the first mold, and having at least one movable mechanism connected to an internal space of the second mold; and a pressure transmission mechanism, pressing a viscous member enclosed in the internal space of the second mold. In a state where the first mold and the second mold are closed, the electronic component is pressurized by the movable mechanism via the viscous member based on a pressing force with which the pressure transmission mechanism presses the viscous member.

Another aspect of the invention provides a mounting method for mounting one or more electronic components on at least one substrate. The mounting method includes: preparing a first mold configured to hold the substrate on which the electronic component is placed; preparing a second mold disposed to oppose the first mold, the second mold having at least one movable mechanism connected to an internal space of the second mold; preparing a pressure transmission mechanism that presses a viscous member enclosed in the internal space of the second mold. The mounting method further includes: closing the first mold and the second mold; pressing the viscous member by the pressure transmission mechanism; and in a state where the first mold and the second mold are closed, pressurizing the electronic component by the movable mechanism via the viscous member based on a pressing force with which the pressure transmission mechanism presses the viscous member.

### Effects of Invention

According to the invention, it is possible to provide a compact mounting device capable of suppressing mounting defects from occurring and a mounting method using the same.

### BRIEF DESCRIPTION OF DRAWINGS

[FIG. 1] FIG. 1 is a view showing an overall schematic configuration of a mounting device according to an embodiment of the invention.
[FIG. 2] FIG. 2 is a flowchart showing a portion of a mounting method according to an embodiment of the invention.
[FIG. 3] FIG. 3 is a flowchart showing a portion of the mounting method according to an embodiment of the invention.
[FIG. 4] FIG. 4 is a graph showing a temperature profile of the mounting method according to an embodiment of the invention.
[FIG. 5] FIG. 5 is a view showing the mounting device in one step of the mounting method.
[FIG. 6] FIG. 6 is a view showing the mounting device in one step of the mounting method.
[FIG. 7] FIG. 7 is a view showing the mounting device in one step of the mounting method.
[FIG. 8] FIG. 8 is a view showing the mounting device in one step of the mounting method.
[FIG. 9] FIG. 9 is a view showing the mounting device in one step of the mounting method.
[FIG. 10] FIG. 10 is a view showing the mounting device in one step of the mounting method.
[FIG. 11] FIG. 11 is a view showing the mounting device in one step of the mounting method.
[FIG. 12] FIG. 12 is a view showing an overall schematic configuration of a mounting device according to a modification example of the invention.
[FIG. 13] FIG. 13 is a diagram showing an overall schematic configuration of a mounting device according to a modification example of the invention.

### DESCRIPTION OF EMBODIMENTS

Embodiments of the invention are described below. In the following description of the drawings, the same or similar components are represented by the same or similar reference numerals. The drawings are illustrative, and the dimensions, shapes, and numbers of the respective components are schematic, and the technical scope of the invention should not be construed as being limited to the embodiments.

### <Mounting device>

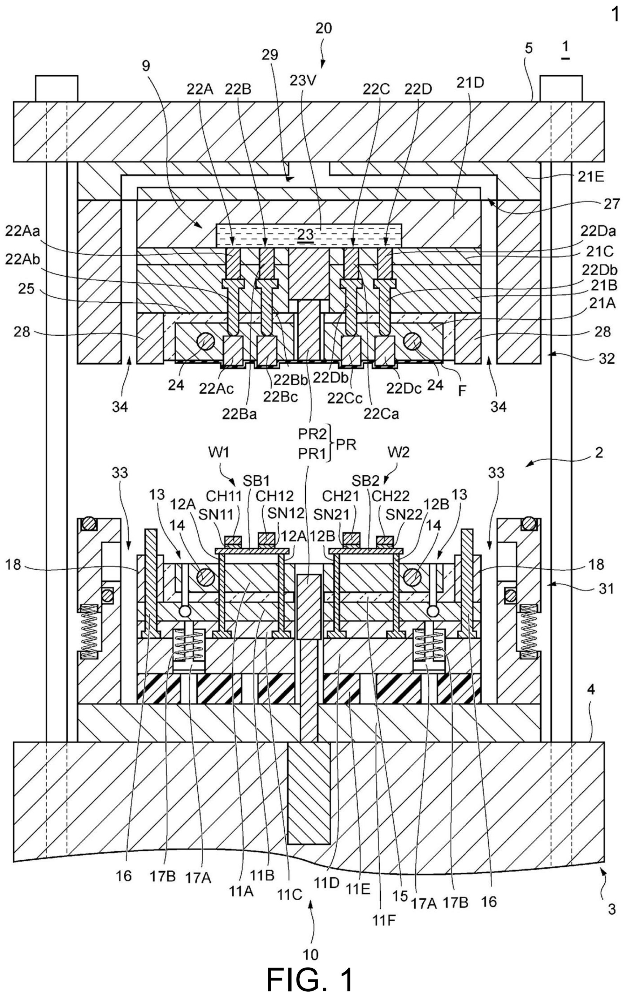

First, the configuration of a mounting device 1 according to an embodiment of the invention is described with reference to FIG. 1. FIG. 1 is a view showing an overall schematic configuration of the mounting device according to an embodiment of the invention.

The mounting device 1 performs a mounting process on workpieces W1, W2. The workpiece W1 includes electronic components CH11, CH12, bonding materials SN11, SN12, and a substrate SB1. The workpiece W2 includes electronic components CH21, CH22, bonding materials SN21, SN22, and a substrate SB2. That is, the mounting device 1 mounts the electronic component CH11 on the substrate SB1 via the bonding material SN11, mounts the electronic component CH12 on the substrate SB1 via the bonding material SN12, mounts the electronic component CH21 on the substrate SB2 via the bonding material SN21, and mounts the electronic component CH22 on the substrate SB2 via the bonding material SN22. Inside the mounting device 1, the workpiece W1 is disposed, so that the substrate SB1 opposes a lower mold 10 and the electronic components CH11, CH12 oppose an upper mold 20, and the workpiece W2 is disposed, so that the substrate SB2 opposes the lower mold 10, and the electronic components CH21, CH22 oppose the upper mold 20. Before the mounting process is performed by the mounting device 1, the electronic components CH11, CH12 are placed on the substrate SB1, and the electronic components CH21, CH22 are disposed on the substrate SB2. After the mounting process is performed by the mounting device 1, the electronic components CH11, CH12 are bonded to the substrate SB1, and the electronic components CH21, CH22 are bonded to the substrate SB2. In the following description, the side where the electronic components CH11, CH12, CH21, CH22 are provided is referred to as the front surfaces of the substrates SB1, SB2, and the opposite side is referred to as the back surfaces of the substrates SB1, SB2.

The electronic components CH11, CH12, CH21, CH22 are, for example, semiconductor chips. The substrates SB1, SB2 are direct bonded aluminum (DBA) substrates (high heat dissipation ceramic insulating substrates with aluminum circuits) or direct bonded copper (DBC) substrates (high heat dissipation ceramic insulating substrates with copper circuits). The bonding materials SN11, SN12, SN21, SN22 are, for example, sintering materials containing silver (Ag) nanoparticles. The mounting device 1 is a sintering device that sinters the bonding materials SN11, SN12, SN21, SN22 by heating and pressurizing. The thickness of each of the substrates SB1, SB2 is, for example, different from each other, but may also be the same. The height of each of the electronic components CH11, CH12 is, for example, different from each other, but may also be the same. The height of each of the electronic components CH21, CH22 is, for example, different from each other, but may also be the same. The thickness of each of the bonding materials SN11, SN12, SN21, SN22 may be the same. Additionally, the number of electronic components for one substrate is at least one and is not limited to two.

The mounting device according to an embodiment of the invention is not limited to a sintering device, as long as the mounting pressurizes electronic components, and may be an appropriate device such as a flip chip bonder. Additionally, the electronic component according to an embodiment of the invention is not limited to a semiconductor chip, and may be, for example, a passive element such as a resistor, an inductor, a capacitor, or a crystal oscillator, or may be an active element such as a diode, a transistor, a thyristor, or an operational amplifier.

The substrate according to an embodiment of the invention is not limited to a ceramic substrate, and may be, for example, a semiconductor substrate such as a silicon substrate, a metal substrate such as a lead frame, or an insulator substrate such as a printed circuit board (PCB) substrate. Additionally, the substrate may be an electronic component, and in this case, the mounting device according to an embodiment of the invention is a device that bonds electronic components to each other. The bonding material according to an embodiment of the invention is not limited to a sintering material, and may be a semi-sintering material, a metal solder, an organic adhesive, or an inorganic adhesive. The form of the bonding material is, for example, an aggregate of powder, but may be liquid, semi-solid, solid, or film-like.

The number of substrates according to an embodiment of the invention is not limited to two, and may be at least one. Similarly, the number of electronic components is not limited to four, and at least one may be provided on one substrate. One or more electronic components are mounted on one substrate.

As shown in FIG. 1, the mounting device 1 includes a press device 3 and a mold 2 attached to the press device 3. In the illustrated example, the mounting device 1 further includes degassing chambers 31, 32, but the degassing chambers are not necessarily required. The press device 3 includes a pair of upper and lower platens 4, 5 connected by tie bars, and a lower plunger PR1.

The mold 2 includes an upper mold base 21E fixed to the upper platen 5 and a lower mold base 11F fixed to the lower platen 4. Main plates (support plates 21D, 21C, upper mold chase 21B, lower mold chase 11B, ejector pin plate 11C, retainer plate 11D, etc.) forming the mold 2 are fixed between the upper mold base 21E and the lower mold base 11F.

In the following description, the various plates fixed to the lower mold base 11F and the components thereof are collectively referred to as the lower mold 10, and the various plates fixed to the upper mold base 21E and the components thereof are collectively referred to as the upper mold 20. The lower mold 10 is an example of "first mold," and the upper mold 20 is an example of "second mold."

The lower mold 10 mainly includes the lower mold base 11F, support pillars 11E, the retainer plate 11D, the ejector pin plate 11C, the lower mold chase 11B, and the like. The lower mold chase 11B is fixed above the lower mold base 11F via the support pillars 11E protruding in a columnar shape from the lower mold base 11F.

The ejector pin plate 11C and the retainer plate 11D are disposed below the lower mold chase 11B. In the ejector pin plate 11C and the retainer plate 11D, holes through which the support pillars 11E penetrate are provided. The ejector pin plate 11C and the retainer plate 11D are fixed to each other and are configured to be vertically slidable between the lower mold chase 11B and the lower mold base 11F.

Various components including a cavity plate 11A are fixed to the lower mold chase 11B. In the illustrated example, the cavity plate 11A, a side block 18 for fixing the cavity plate 11A, a heat insulation member 15 disposed to surround the lower and side surfaces of the cavity plate 11A, and springs 17B and spring sleeves 17A are fixed to the lower mold chase 11B.

Multiple lifter pins 12A, 12B capable of protruding from and retracting into the cavity plate 11A, and set pins 16 that abut against the upper mold 20 when the mold is clamped, are fixed to the ejector pin plate 11C and the retainer plate 11D.

The cavity plate 11A is provided at a position closest to the upper mold 20 and contacts the space between the lower mold 10 and the upper mold 20 when the mold is open. A heater 14 is provided inside the cavity plate 11A. When the lower mold 10 and the upper mold 20 are closed, the heater 14 heats the substrates SB1, SB2 via the cavity plate 11A. As a result, the bonding materials SN11, SN12, SN21, SN22 are heated.

The heat insulation member 15 is provided between the cavity plate 11A and the lower mold chase 11B, and between the cavity plate 11A and the side block 18. The heat insulation member 15 suppresses direct thermal conduction from the cavity plate 11A to the lower mold chase 11B, and suppresses thermal conduction from the cavity plate 11A to the lower mold chase 11B via the side block 18.

In other words, the heat insulation member 15 is disposed to separate the gas piping provided in the lower mold chase 11B and the heater 14, and suppresses the temperature rise of the nitrogen gas supplied from the gas supply port 13. Additionally, the heat insulation member 15 is disposed to separate the spring 17B and the heater 14, and suppresses the decrease in the elastic force of the spring 17B. That is, the heat insulation member 15 limits the heating target to the cavity plate 11A, thereby accelerating the temperature rise by the heater 14 and making other members less susceptible to the influence of heat.

The side block 18 is provided on the side of the lower mold chase 11B that opposes the upper mold 20. When viewed in a plan view from the upper mold 20, the side block 18 is provided on the outer side of the cavity plate 11A. The side block 18 abuts against the upper mold 20 when the lower mold 10 and the upper mold 20 are closed. In the illustrated example, a gas supply port 13 for supplying gas such as nitrogen (N2) gas is provided on the side of the heat insulation member 15 outer with respect to the heater 14 of the cavity plate 11A.

The gas supply port 13 supplies gas such as nitrogen (N2) gas toward the electronic components CH11, CH12, CH21, CH22 and the substrates SB1, SB2. The gas supply port 13 is provided on the surface of the cavity plate 11A that opposes the upper mold 20, and opens toward the upper mold 20. Therefore, the gas supply port 13 rapidly removes oxidizing gas from around the workpieces W1, W2 during heating, and places the workpieces W1, W2 in a nitrogen atmosphere.

Additionally, the gas supply port 13 performs gas cooling of the workpieces W1, W2 by directing nitrogen gas at the workpieces W1, W2 during cooling. When viewed in a plan view from the upper mold 20, multiple gas supply ports 13 are provided on the outer side of the workpieces W1, W2. The gas piping through which the nitrogen gas supplied by the gas supply ports 13 passes is provided in the lower mold chase 11B. The gas supply port 13 is an example of "gas supply mechanism" that supplies inert gas to the space between the lower mold 10 and the upper mold 20.

The inert gas supplied by the gas supply port is not limited to nitrogen gas, and may be, for example, carbon dioxide, fluorocarbon, or noble gas. Additionally, the gas supply port may be open toward an electronic component, a bonding material, or a substrate, and may blow inert gas directly onto the electronic component, the bonding material, or the substrate. The gas supply port may be provided in the cavity plate of the upper mold, or may be provided in the cavity plates of both the lower mold and the upper mold. The gas supply port may be provided in the side block of at least one of the lower mold and the upper mold, or may be provided in a degassing chamber described later. Additionally, the inert gas may be omitted.

The spring 17B constantly biases the ejector pin plate 11C and the retainer plate 11D upward toward the lower mold chase 11B. The spring sleeve 17A has a base end part (upper end part) that is a shoulder bolt (or a washer, a sleeve, and a bolt), and is fixed to the lower surface of the lower mold chase 11B. A flange is provided at the tip end part (lower end part) of the spring sleeve 17A.

The retainer plate 11D has a through hole formed therein that is larger than the tip end part of the spring sleeve 17A. The ejector pin plate 11C has a counterbore with the same diameter as the through hole, and a through hole at the center of the counterbore through which the base end part of the spring sleeve 17A is inserted. The spring sleeve 17A is inserted through the through hole of the retainer plate 11D and the through hole of the ejector pin plate 11C.

The spring 17B is provided in a helical shape around the spring sleeve 17A between the flange of the spring sleeve 17A and the counterbore of the ejector pin plate 11C. In other words, the spring sleeve 17A is inserted into the helical spring 17B. The spring 17B exerts an elastic force in a direction that separates the ejector pin plate 11C and the flange at the tip end part of the spring sleeve 17A from each other.

In other words, the spring 17B constantly biases the ejector pin plate 11C and the retainer plate 11D toward the lower mold chase 11B via the spring sleeve 17A. The spring 17B is an example of an elastic member, and the elastic member is not limited to a spring, as long as the elastic force described above can be exerted. The elastic member may be, for example, rubber or a leaf spring.

The lifter pins 12A, 12B are inserted through the inside of the through holes that penetrate the cavity plate 11A, the lower mold chase 11B, the ejector pin plate 11C, and the heat insulation member 15. The lifter pins 12A, 12B have the same length, and three or four or more lifter pins are used to hold the workpiece W1 in parallel. The side of the upper mold 20 is defined as the tip end part, and the side of the lower mold base 11F is defined as the base end part. The base end parts of the lifter pin 12B and the set pin 16 are sandwiched between the ejector pin plate 11C and the retainer plate 11D and are screwed in place. The lifter pin 12B and the set pin 16 move up and down in conjunction with the ejector pin plate 11C and the retainer plate 11D.

The lifter pin 12A supports the substrate SB1 by bringing the tip end part of the lifter pin 12A into contact with the back surface of the substrate SB1, and the lifter pin 12B supports the substrate SB2 by bringing the tip end part of the lifter pin 12B into contact with the back surface of the substrate SB2. The lifter pins 12A, 12B are configured to be movable upward and downward, and bring the substrates SB1, SB2 and the cavity plate 11A into contact with and away from each other.

Specifically, the lifter pins 12A, 12B are configured to be able to advance and retract from the cavity plate 11A toward the upper mold 20. When the lifter pins 12A, 12B are advanced into the space between the lower mold 10 and the upper mold 20 (during mold opening), the workpieces W1, W2 supported by the lifter pins 12A, 12B are separated from the cavity plate 11A. When the lifter pins 12A, 12B are retracted from the space between the lower mold 10 and the upper mold 20 (during mold closing), the workpieces W1, W2 are supported in contact with the cavity plate 11A.

When the ejector pin plate 11C and the retainer plate 11D approach (move upward toward) the cavity plate 11A, the tip end parts of the lifter pins 12A, 12B protrude from the cavity plate 11A. That is, the tip ends of the lifter pins 12A, 12B are advanced into the space between the lower mold 10 and the upper mold 20.

When the ejector pin plate 11C and the retainer plate 11D move away from (move downward from) the cavity plate 11A, the tip end parts of the lifter pins 12A, 12B are housed inside the cavity plate 11A, and the surfaces of the end parts of the lifter pins 12A, 12B become flush with the surface of the cavity plate 11A. That is, the lifter pins 12A, 12B are retracted from the space between the lower mold 10 and the upper mold 20. The lifter pins 12A, 12B are an example of "holding part". The holding part is not limited to lifter pins. The holding part may be an elongated plate-shaped member that holds the end part of the workpiece.

The set pin 16 is inserted through a through hole that penetrates the side block 18, the lower mold chase 11B, and the ejector pin plate 11C. The set pin 16 has a tip end part on the side of the upper mold 20 and a base end part on the side of the lower mold base 11F. The base end part of the set pin 16 is sandwiched between the ejector pin plate 11C and the retainer plate 11D. The tip end part of the set pin 16 faces a side block 28 of the upper mold 20.

When the lower mold 10 and the upper mold 20 are closed, the set pin 16 is pressed by the side block 28 and pushes down the ejector pin plate 11C and the retainer plate 11D. By pushing down the ejector pin plate 11C and the retainer plate 11D, the lifter pin 12B is pushed down in conjunction therewith, causing the substrates SB1, SB2 on the lifter pins 12B to move downward. In addition, in order to push down the ejector pin plate 11C and the retainer plate 11D in parallel, it is preferable that approximately four set pins 16 are disposed at the four corners.

The upper mold 20 mainly includes the upper mold base 21E, the upper support plate 21D, the lower support plate 21C, the upper mold chase 21B, a pressure regulating mechanism 9, and the like. The upper and lower support plates 21D, 21C are fixed to the upper mold base 21E. The upper mold chase 21B is fixed to the upper mold base 21E via the upper support plate 21D and the lower support plate 21C. The pressure regulating mechanism 9 adjusts the pressing force of the lower plunger PR1 of the press device 3 and transmits the pressing force to the workpieces W1, W2.

Various components including the cavity plate 21A are fixed to the upper mold chase 21B. In the illustrated example, the upper mold chase 21B is provided with the cavity plate 21A, the side block 28 that fixes the cavity plate 21A, a heat insulation member 25 disposed to surround the upper surface and the side surfaces of the cavity plate 21A, and a portion of the pressure regulating mechanism 9.

The cavity plate 21A is provided at a position closest to the lower mold 10. A heater 24 is provided inside the cavity plate 21A. The heater 24 heats movable pieces 22Ac, 22Bc, 22Cc, 22Dc described later via the cavity plate 21A. When the lower mold 10 and the upper mold 20 are closed, the heater 24 heats the electronic components CH11, CH12, CH21, CH22 via the movable pieces 22Ac, 22Bc, 22Cc, 22Dc and the film F. In this way, the bonding materials SN11, SN12, SN21, SN22 are heated.

The side block 28 is provided on a side of the upper mold chase 21B opposing the lower mold 10. When viewed in a plan view from the upper mold 20, the side block 28 is provided on the outer side of the cavity plate 21A. The side block 28 is a portion of the upper mold 20 that contacts the lower mold 10 when the lower mold 10 and the upper mold 20 are closed. That is, when the lower mold 10 and the upper mold 20 are closed, the side block 28 contacts the set pin 16. When the lower mold 10 and the upper mold 20 are closed, the side block 28 may be spaced apart from the set pin 16.

The heat insulation member 25 is provided between the cavity plate 21A and the upper mold chase 21B, and is provided between the cavity plate 21A and the side block 28. The heat insulation member 25 suppresses the direct thermal conduction from the cavity plate 21A to the upper mold chase 21B, and suppresses the thermal conduction from the cavity plate 21A to the upper mold chase 21B via the side block 28. The heat insulation member 25 partitions the heater 24 and the internal space 23, thereby suppressing property change and thermal degradation due to the temperature rise of a viscous member 23V. That is, the heat insulation member 25 limits the heating target to the cavity plate 21A, thereby accelerating the temperature rise by the heater 24 and making other members less susceptible to the influence of heat.

When performing the mounting process, a film F is stretched on a surface of the cavity plate 21A opposing the lower mold 10. A suction hole (not shown) for suctioning the film F is provided on the lower surface of the cavity plate, and adsorbs the film F. The suction hole is connected to an external vacuum suction pump and controls ON and OFF of adsorption.

As an example of the film F, a film material excellent in heat resistance, ease of peeling, flexibility, and extensibility is suitably used, such as polytetrafluoroethylene (PTFE), ethylene-tetrafluoroethylene (ETFE) copolymer, polyethylene terephthalate (PET), tetrafluoroethylene-hexafluoropropylene (FEP) copolymer, fluorine-impregnated glass cloth, polypropylene (PP), polyvinylidene chloride (PVDC), etc.

The film F inhibits the intrusion of powder and gas generated from the bonding materials SN11, SN12, SN21, SN22 into the gap of the upper mold 20, and suppresses the malfunctioning of the upper mold 20. In addition, the film F serves as a cushioning material between the movable pieces 22Ac, 22Bc, 22Cc, 22Dc and the electronic components CH11, CH12, CH21, CH22, and has an effect of suppressing damages to the electronic components CH11, CH12, CH21, CH22 during pressurization.

The pressure regulating mechanism 9 includes an upper plunger PR2 driven by the lower plunger PR1 of the press device 3, a viscous member 23V compressed by the upper plunger PR2, and movable mechanisms 22A, 22B, 22C, 22D that receive a pressure from the viscous member 23V and pressurize the workpieces W1, W2. Various components forming the pressure regulating mechanism 9 are disposed across the upper mold chase 21B and the upper and lower support plates 21D, 21C.

The movable mechanisms 22A, 22B, 22C, 22D are connected to the internal space 23 and configured to be movable up and down. The movable mechanisms 22A, 22B, 22C, 22D have a base end part on the side of the upper mold base 21E and a tip end part on the side of the lower mold 10. The movable mechanism 22A receives the internal pressure of the internal space 23, which increases with the plunger PR pressing the viscous member 23V, at the base end part connected to the internal space 23, and moves up and down. The movable mechanism 22A contacts the electronic component CH11 at the tip end part via the film F, and pressurizes the electronic component CH11 by the internal pressure of the internal space 23 transmitted from the base end part to the tip end part. That is, the electronic component CH11 is pressurized by the movable mechanism 22A via the viscous member 23V based on the pressing force of the plunger PR pressing the viscous member 23V. As a result, the bonding material SN11 is pressurized by the movable mechanism 22A via the electronic component CH11.

Similarly, the electronic component CH12 is pressurized by the movable mechanism 22B via the viscous member 23V based on the pressing force of the plunger PR pressing the viscous member 23V, and the bonding material SN12 is pressurized by the movable mechanism 22B via the electronic component CH12. The electronic component CH21 is pressurized by the movable mechanism 22C via the viscous member 23V based on the pressing force of the plunger PR pressing the viscous member 23V, and the bonding material SN21 is pressurized by the movable mechanism 22C via the electronic component CH21. The electronic component CH21 is pressurized by the movable mechanism 22D via the viscous member 23V based on the pressing force of the plunger PR pressing the viscous member 23V, and the bonding material SN21 is pressurized by the movable mechanism 22D via the electronic component CH21. The internal pressure of the internal space 23 acting on each of the movable mechanisms 22A, 22B, 22C, 22D is substantially equal regardless of the positions of the movable mechanisms 22A, 22B, 22C, 22D in the direction in which the lower mold 10 and the upper mold 20 oppose each other. Therefore, regardless of the differences in thickness of the substrates SB1, SB2, the differences in height of the electronic components CH11, CH12, CH21, CH22, and the differences in thickness of the bonding materials SN11, SN12, SN21, SN22, the bonding materials SN11, SN12, SN21, SN22 are pressurized with substantially equal pressure.

The movable mechanism 22A includes a piston 22Aa, a rod 22Ab, and a movable piece 22Ac. The movable mechanism 22B includes a piston 22Ba, a rod 22Bb, and a movable piece 22Bc. The movable mechanism 22C includes a piston 22Ca, a rod 22Cb, and a movable piece 22Cc. The movable mechanism 22D includes a piston 22Da, a rod 22Db, and a movable piece 22Dc.

The piston 22Aa is provided at the base end part of the movable mechanism 22A. The piston 22Aa is connected to the internal space 23. That is, the piston 22Aa is in contact with the viscous member 23V. The piston 22Aa is provided to be slidable with respect to the upper mold chase 21B and the lower support plate 21C. The piston 22Aa and the lower support plate 21C are in liquid-tight contact so that the viscous member 23V does not leak. The piston 22Aa receives the internal pressure of the internal space 23 changed by the pressing of the viscous member 23V by the plunger PR, and moves in the vertical direction.

The rod 22Ab is provided between the piston 22Aa and the movable piece 22Ac. The rod 22Ab is provided to be slidable with respect to the cavity plate 21A, the upper mold chase 21B, and the heat insulation member 25. The rod 22Ab is connected to the piston 22Aa at the base end part, and the tip end part is rounded in a bullet shape and in point contact with the movable piece 22Ac. The rod 22Ab transmits the pressure mutually between the piston 22Aa and the movable piece 22Ac.

The movable piece 22Ac is provided at the tip end part of the movable mechanism 22A. The movable piece 22Ac is provided to be slidable with respect to the cavity plate 21A. The tip end part of the movable piece 22Ac protrudes from the cavity plate 21A. The movable piece 22Ac is a movable insert that moves vertically and is prevented from falling. When the lower mold 10 and the upper mold 20 are closed, the tip end part of the movable piece 22Ac contacts the upper surface of the electronic component CH11 via the film, and applies the pressure transmitted from the piston 22Aa to the electronic component CH11.

Since the structures and the functions of the pistons 22Ba, 22Ca, and 22Da are similar to the structure and the function of the piston 22Aa, the description of the pistons 22Ba, 22Ca, and 22Da is omitted. Since the structures and the functions of the rods 22Bb, 22Cb, and 22Db are similar to the structure and the function of the rod 22Ab, the description of the rods 22Bb, 22Cb, and 22Db is omitted. Since the structures and the functions of the movable pieces 22Bc, 22Cc, and 22Dc are similar to the structure and the function of the movable piece 22Ac, the description of the movable pieces 22Bc, 22Cc, and 22Dc is omitted. The side of the movable pieces 22Ac, 22Bc, 22Cc, and 22Dc that contacts the electronic components CH11, CH12, CH21, and CH22 is covered by a continuous film F.

The internal space 23 is formed between the lower support plate 21C and the upper support plate 21D. In the internal space 23, the pistons 22Aa, 22Ba, 22Ca, and 22Da of the movable mechanisms 22A, 22B, 22C, and 22D, and the upper plunger PR2 of the plunger PR are connected. That is, the inner wall of the internal space 23 is formed by the lower support plate 21C, the upper support plate 21D, the pistons 22Aa, 22Ba, 22Ca, and 22Da, and the upper plunger PR2. The internal space 23 is independent from the external space of the upper mold 20. That is, the internal space 23 is a closed system in which the viscous member 23V neither enters nor exits from the upper mold 20.

The viscous member 23V is enclosed in the internal space 23. The viscous member 23V is a fluid more viscous than water. For example, the viscosity coefficient of the viscous member 23V at 25°C is 1 Pa·s or more and 200 Pa·s or less. According to this, even in the case where the viscous member 23V is heated by the heater 24, a sufficient viscosity can be maintained. However, the viscosity coefficient of the viscous member 23V may be 1 Pa·s or more and 200 Pa·s or less in the temperature range where the viscous member 23V is used. The material of the viscous member 23V is, for example, silicone oil. However, the invention is not limited thereto. Due to the viscosity, the viscous member 23V is less likely to leak from the gap between the lower support plate 21C and the upper plunger PR2 and the gap between the lower support plate 21C and the pistons 22Aa, 22Ba, 22Ca, and 22Da, than water or air. In addition, since the compressibility of the viscous member 23V is lower than that of gas such as air, by enclosing the viscous member 23V instead of gas in the internal space 23, the loss of pressing force by the plunger PR in the internal space 23 can be reduced. The material of the viscous member 23V may be a material having excellent heat resistance. Specifically, the material of the viscous member 23V may be a material in which the change in viscosity is small in the temperature change range of the upper mold chase 21B, the lower support plate 21C, and the upper support plate 21D in the case where the heater 24 heats the cavity plate 21A.

The plunger PR is an example of "pressure transmission mechanism" that presses the viscous member 23V enclosed in the internal space 23 of the upper mold 20. The plunger PR includes the lower plunger PR1 and the upper plunger PR2.

The lower plunger PR1 is detachably erected on a plunger unit that is a conventional transfer drive source (not shown, see, for example, Japanese Patent Application Laid-Open Publication No. H9-155911, Japanese Patent Application Laid-Open Publication No. 2013-26360, and Japanese Patent Application Laid-Open Publication No. 2019-1122) provided at a lower portion of a movable platen that moves the lower mold 10 up and down. In the case of normal transfer molding, an equalizing pressure mechanism is incorporated in the plunger unit, but in the case of the invention, the equalizing pressure mechanism be omitted. The lower plunger PR1 is inserted through a through hole penetrating the cavity plate 11A, the lower mold chase 11B, the ejector pin plate 11C, the retainer plate 11D, the heat insulation member 15, the support pillar 11E, and the lower mold base 11F. The lower plunger PR1 has the side of the upper mold 20 as a tip end part and the opposite side as a base end part. The tip end part of the lower plunger PR1 has a diameter expanded with respect to the base end part of the lower plunger PR1. A pot (not shown) may be provided in the lower mold 10, and the tip end part of the lower plunger PR1 may be disposed inside the pot and guided. The lower plunger PR1 is configured to be movable up and down by a plunger unit (not shown). When the lower plunger PR1 moves down to the limit of the movable range, the tip of the lower plunger PR1 is housed in, for example, the cavity plate 11A, but the upper surface of the tip of the lower plunger PR1 may be at the same surface height as the upper surface of the cavity plate 11A. The lower plunger PR1 and the upper plunger PR2 are in opposing arrangement, and when the lower plunger PR1 moves up, the tip of the lower plunger PR1 protrudes from the cavity plate 11A. When the lower mold 10 and the upper mold 20 are closed, and the lower plunger PR1 moves up, the tip of the lower plunger PR1 contacts the tip of the upper plunger PR2. When the lower plunger PR1 further moves up, the lower plunger PR1 presses the upper plunger PR2 upward. The base end part of the lower plunger PR1 is connected to a plunger unit (not shown). The lower plunger PR1 is an example of "first pressure transmission part".

The upper plunger PR2 is provided in the upper mold 20. The upper plunger PR2 is inserted through a through hole penetrating the cavity plate 21A, the upper mold chase 21B, the lower support plate 21C, and the heat insulation member 25. The upper plunger PR2 has the side of the lower mold 10 as a tip end part and the opposite side as a base end part. The base end part (upper end surface) of the upper plunger PR2 has a diameter expansion compared to the tip end part of the upper plunger PR2, and is provided to be slidable with respect to the upper mold chase 21B and the lower support plate 21C. A pot (not shown) may be provided in the upper mold 20, and the base end part of the upper plunger PR2 may be disposed inside the pot and guided. The base end part of the upper plunger PR2 is connected to the internal space 23. The tip end part (lower end surface) of the upper plunger PR2 is exposed at the cavity plate 21A. The upper plunger PR2 is pressed by the lower plunger PR1 and presses the viscous member 23V. The upper plunger PR2 is an example of "second pressure transmission part". The upper plunger PR2 forms a pair with the lower plunger PR1, and a pair of plungers are configured.

In the cross-section shown in FIG. 1, only one lower plunger and one upper plunger are illustrated, respectively, but multiple lower plungers and multiple upper plungers may be provided. Such multiple lower plungers and multiple upper plungers are provided, for example, side-by-side in the depth direction of the drawing in FIG. 1. Each of the upper plungers forms a pair with each of the same number of lower plungers, and multiple pairs of plungers are configured. The pairs of plungers can transmit pressures independently of each other. However, the number of lower plungers may differ from the number of upper plungers. One upper plunger may be pressed by multiple lower plungers, and multiple upper plungers may be pressed by one lower plunger. Multiple upper plungers may be pressed by fewer multiple lower plungers, and multiple upper plungers may be pressed by more multiple lower plungers. Therefore, for the plungers, at least one lower plunger and at least one upper plunger may be provided. In the case where multiple upper plungers are provided for the plungers, the upper mold may have multiple internal spaces partitioned from each other and multiple viscous members enclosed in the respective internal spaces. The internal spaces may be provided, for example, by being arranged side-by-side in the depth direction of the drawing in FIG. 1. The respective viscous members may be pressed by separate upper plungers. In such a configuration, even for electronic components mounted on one substrate, the viscous member through which the pressure is applied differs, so the magnitude of the pressure for pressurizing the electronic component can be changed according to the mounting position.

The pressure transmission mechanism has the lower plunger PR1 and the upper plunger PR2, and is not limited to the plunger PR that presses the viscous member 23V from below the internal space 23. The pressure transmission mechanism may be configured to press the viscous member 23V from above the internal space 23, and may be configured to press the viscous member 23V from the lateral direction of the internal space 23. Here, the lateral direction is a direction intersecting the direction in which the lower mold 10 and the upper mold 20 oppose each other. The pressure transmission mechanism may be configured to press the viscous member 23V from multiple directions of the internal space 23.

The degassing chambers 31, 32 are annular vacuum chambers that are openable and closable and surround the lower mold 10 and the upper mold 20. The degassing chamber 31 is erected on the lower mold base 11F of the lower mold 10. When viewed in a plan view from the upper mold 20, the degassing chamber 31 is provided on the outer side of the side block 18. A degassing path 33 through which the degassing gas passes is provided between the degassing chamber 31 and the lower mold chase 11B, the ejector pin plate 11C, the retainer plate 11D, the support pillar 11E, and the side block 18. The degassing chamber 32 is erected downward on the upper mold base 21E of the upper mold 20. When viewed in a plan view from the lower mold 10, the degassing chamber 32 is provided on the outer side of the side block 28. A degassing path 34 through which the degassing gas passes is provided between the degassing chamber 32 and the upper mold chase 21B, the lower support plate 21C, the upper support plate 21D, and the side block 28. The degassing path 34 is connected to a degassing path 27 provided in the upper mold base 21E. The degassing path 27 is connected to a degassing port 29 provided in the upper mold base 21E. The degassing port 29 is connected to a vacuum pump outside the mold. With the degassing port 29, the atmosphere of the lower mold 10 and the upper mold 20 in the degassing chambers 31, 32 is degassed.

### <Mounting method>

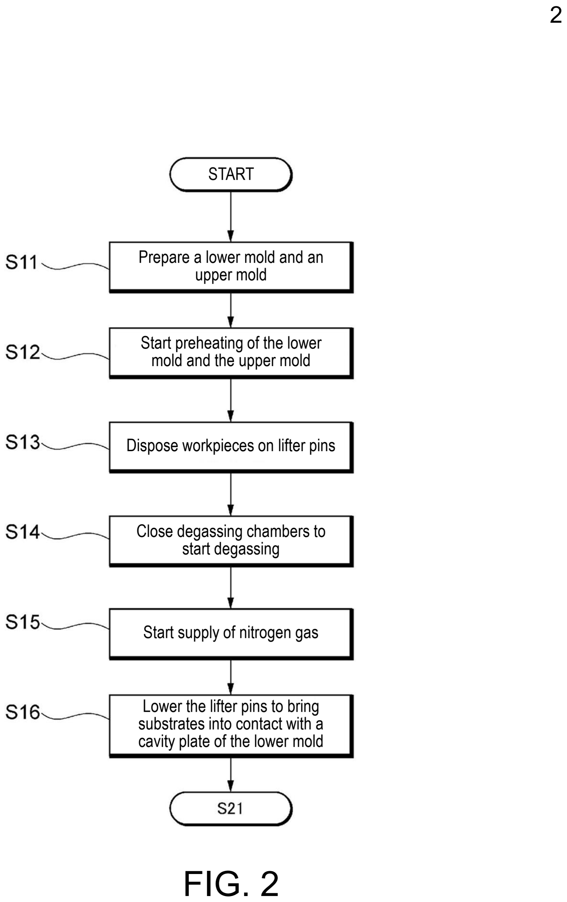

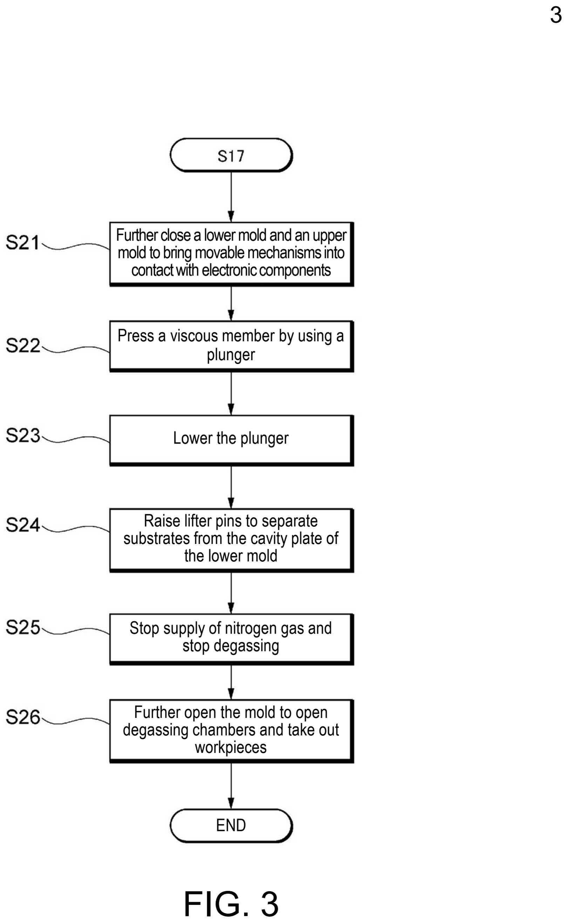

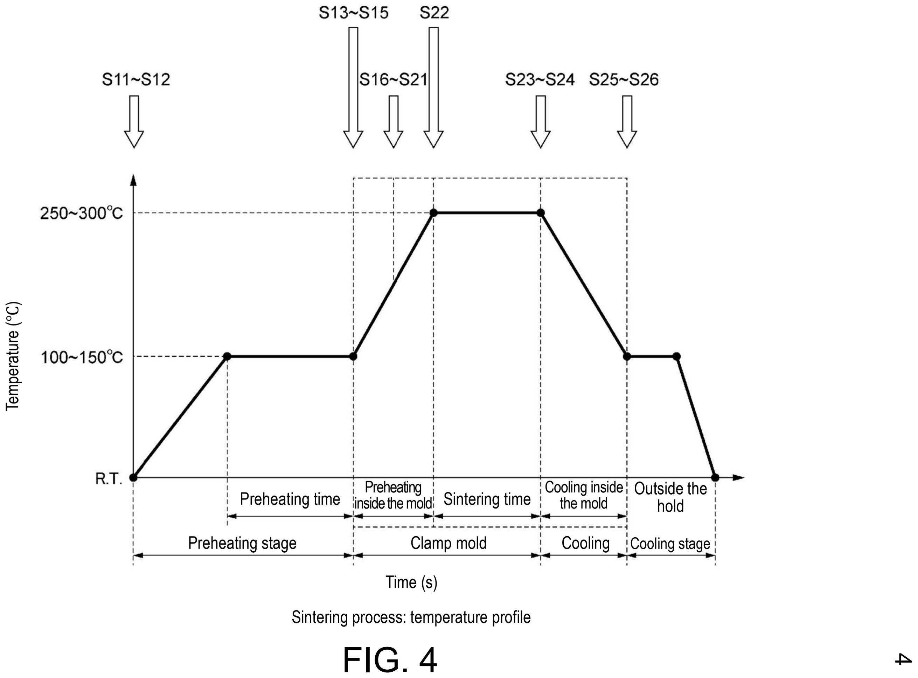

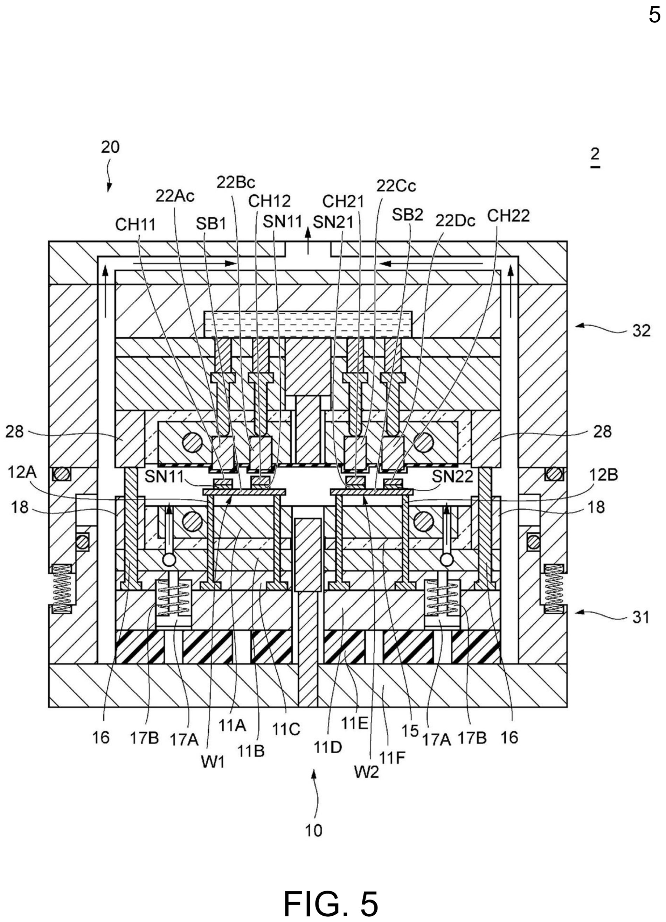

Next, a mounting method using the mounting device 1 according to the embodiment will be described with reference to FIG. 2 to FIG. 11. FIG. 2 and FIG. 3 are flowcharts showing portions of the mounting method according to an embodiment of the invention. FIG. 4 is a graph showing a temperature profile of the mounting method according to an embodiment of the invention. FIG. 5 to FIG. 11 are views showing the mounting device at one step of the mounting method. In the graph of FIG. 4, the horizontal axis indicates time, and the vertical axis indicates the temperature of the workpiece.

First, the lower mold 10 and the upper mold 20 are prepared (S11), and preheating of the lower mold 10 and the upper mold 20 is started (S12). As shown in FIG. 4, the temperature of the workpieces W1, W2 at this time is room temperature (R.T.).

Next, the workpieces W1, W2 are disposed on the lifter pins 12A, 12B (S13). Next, the degassing chambers 31, 32 are closed to start degassing (S14), and the supply of nitrogen gas is started (S15). Before raising the temperature of the bonding materials SN11, SN12, SN21, SN22 to the sintering process temperature, degassing is performed and a nitrogen gas atmosphere is created, thereby suppressing the oxidation of the bonding materials SN11, SN12, SN21, SN22. As shown in FIG. 5, when the degassing chambers 31, 32 are closed, the tip end part of the set pin 16 abuts against the side block 28 of the upper mold 20. However, since the side blocks 18, 28 of the lower mold 10 and the upper mold 20 are spaced apart from each other, the workpieces W1, W2 are spaced upward from the cavity plate 11A. The substrates SB1, SB2 are heated by thermal radiation from the cavity plate 11A of the lower mold 10, and although not in contact with the movable pieces 22Ac, 22Bc, 22Cc, 22Dc of the upper mold 20, the electronic components CH11, CH12, CH21, CH22 are gradually heated by thermal radiation. As shown in FIG. 4, the temperature of the workpieces W1, W2 at this time is approximately 100°C to 150°C.

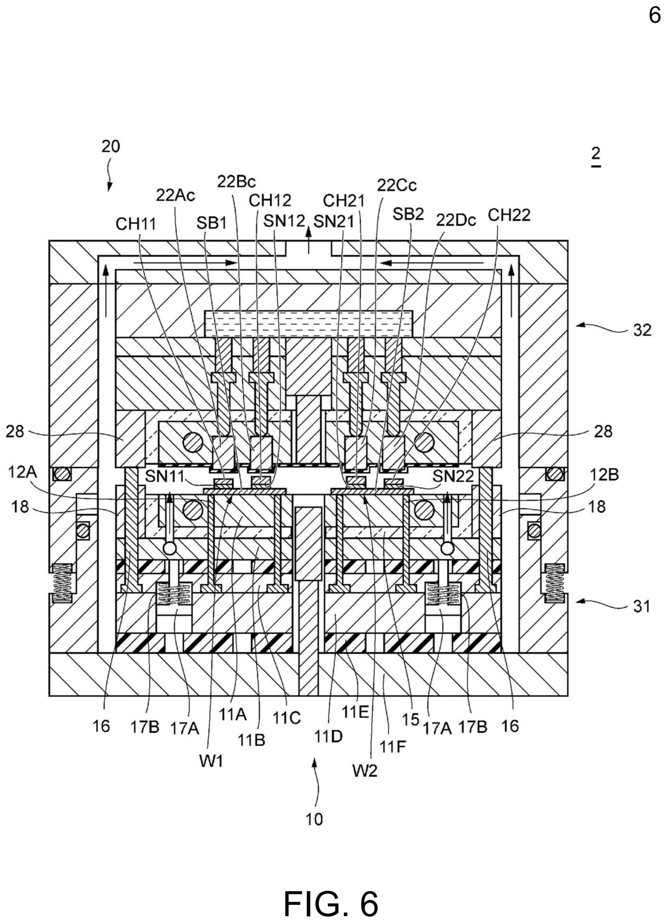

Next, the mold closes a little further, the lifter pins 12A, 12B are lowered, and the substrates SB1, SB2 are brought into contact with the cavity plate 11A of the lower mold 10 (S16). As shown in FIG. 6, as the lower mold 10 and the upper mold 20 approach each other, the tip end part of the set pin 16 abuts against the side block 28 of the upper mold 20, and the set pin 16 is pushed down. The set pin 16 that is pushed down pushes down the ejector pin plate 11C and the retainer plate 11D connected to the base end part of the set pin 16, and pushes down the lifter pins 12A, 12B whose base end parts are connected to the ejector pin plate 11C and the retainer plate 11D. As a result, the workpieces W1, W2 contact the cavity plate 11A. The substrates SB1, SB2 are heated by the thermal conduction from the cavity plate 11A of the lower mold 10, and although not in contact with the movable pieces 22Ac, 22Bc, 22Cc, 22Dc of the upper mold 20, the electronic components CH11, CH12, CH21, CH22 are heated by thermal radiation. As shown in FIG. 4, the temperature of the workpieces W1, W2 at this time is raised from the preheating temperature of 100°C to 150°C to the sintering process temperature of 250°C to 300°C.

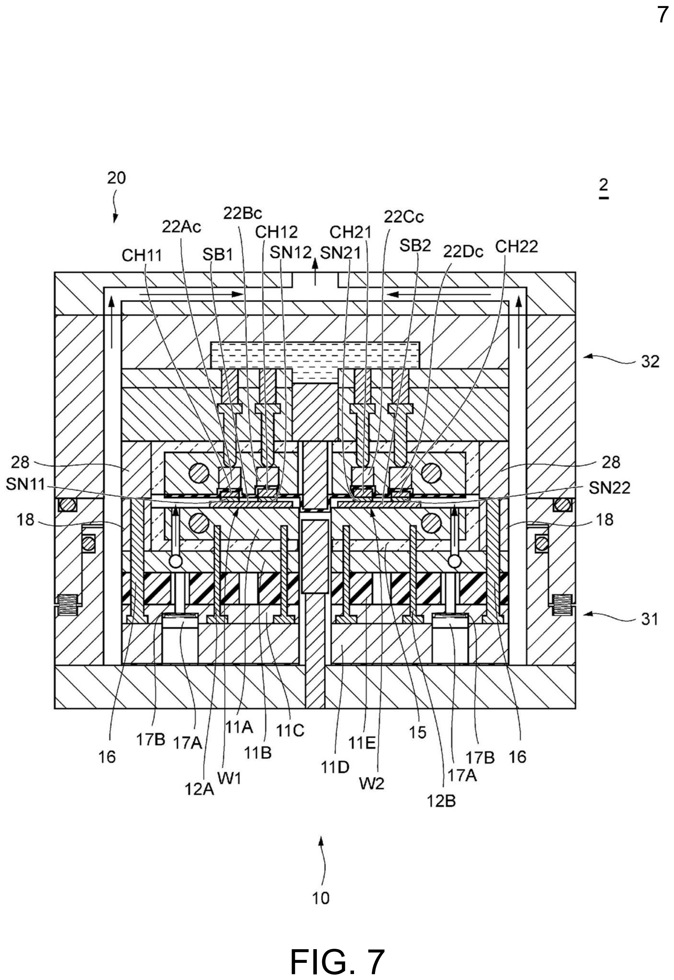

Next, the lower mold 10 and the upper mold 20 are further closed, and the movable mechanisms 22A, 22B, 22C, 22D contact the electronic components CH11, CH12, CH21, CH22 (S21). As shown in FIG. 7, the side blocks 18, 28 of the lower mold 10 and the upper mold 20 abut against each other, and when mold closing is completed, the set pin 16 is pushed down to the maximum. The movable piece 22Ac of the movable mechanism 22A abuts against the electronic component CH11 via the film, and the piston 22Aa of the movable mechanism 22A is pushed up. The movable piece 22Bc of the movable mechanism 22B abuts against the electronic component CH12 via the film, and the piston 22Ba of the movable mechanism 22B is pushed up. The movable piece 22Cc of the movable mechanism 22C abuts against the electronic component CH21 via the film, and the piston 22Ca of the movable mechanism 22C is pushed up. The movable piece 22Dc of the movable mechanism 22D abuts against the electronic component CH22 via the film, and the piston 22Da of the movable mechanism 22D is pushed up. The penetration depths of the pistons 22Aa, 22Ba, 22Ca, 22Da into the internal space 23 differ from each other due to the differences in dimension among the substrates SB1, SB2, the bonding materials SN11, SN12, SN21, SN22, and the electronic components CH11, CH12, CH21, CH22. With the movable mechanisms 22A, 22B, 22C, 22D contacting the electronic components CH11, CH12, CH21, CH22, the adhesion between the cavity plate 11A of the lower mold 10 and the substrates SB1, SB2 is improved. Therefore, compared to Step S16 in which the substrates SB1, SB2 are mounted on the cavity plate 11A, the efficiency of the thermal conduction from the lower mold 10 to the substrates SB1, SB2 is improved, and the heating efficiency of the bonding materials SN11, SN12, SN21, SN22 by the lower mold 10 is improved. In addition, the electronic components CH11, CH12, CH21, CH22 are heated by the thermal conduction from the movable pieces 22Ac, 22Bc, 22Cc, 22Dc of the upper mold 20. Therefore, compared to Steps S13 to S16 in which the electronic components CH11, CH12, CH21, CH22 are heated by thermal radiation, the heating efficiency of the bonding materials SN11, SN12, SN21, SN22 by the upper mold 20 is improved. As shown in FIG. 4, the temperature of the workpieces W1, W2 at this time is raised from the preheating temperature of 100°C to 150°C to the sintering process temperature of 250°C to 300°C.

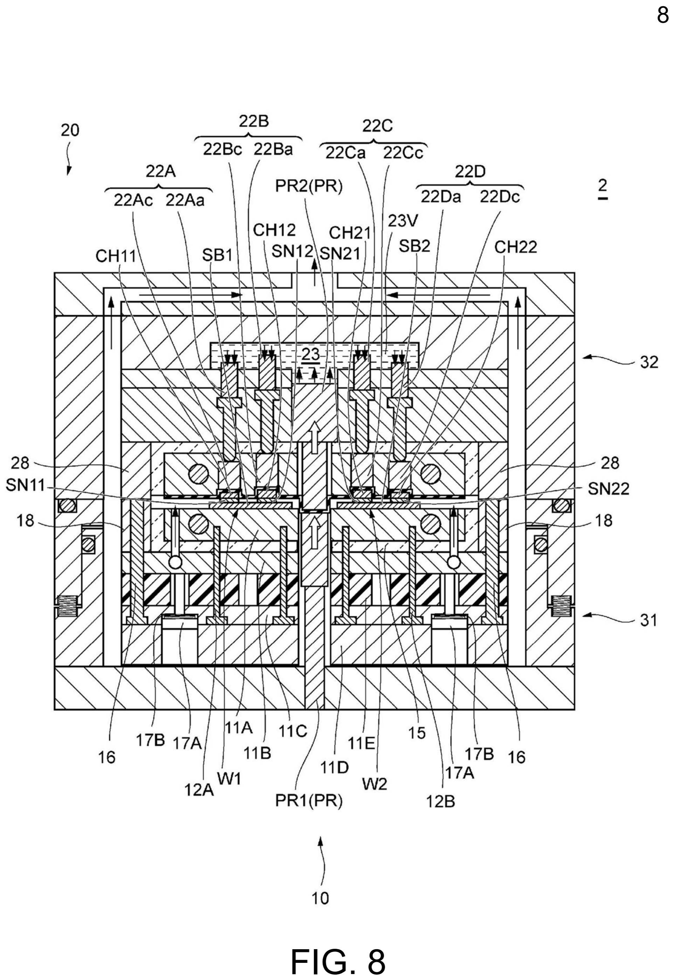

Next, the viscous member 23V is pressed by the plunger PR (S22). As shown in FIG. 8, when the lower plunger PR1 is pushed up by a conventional transfer mechanism while the lower mold 10 and the upper mold 20 are closed, the tip end part of the upper plunger PR2 abuts against the tip end part of the lower plunger PR1, and the upper plunger PR2 is pushed up by the lower plunger PR1. When the lower mold 10 and the upper mold 20 are closed, the tip end part of the upper plunger PR2 may abut against the tip end part of the lower plunger PR1 even if the lower plunger PR1 is not pushed up by the transfer mechanism. The lower plunger PR1 presses the viscous member 23V with a predetermined pressing force via the upper plunger PR2. The internal pressure of the internal space 23, which is raised by being pressed by the upper plunger PR2, is equally applied to the pistons 22Aa, 22Ba, 22Ca, 22Da. The movable mechanism 22A moves based on the internal pressure of the internal space 23 applied to the piston 22Aa, that is, the pressing force of the plunger PR, and pressurizes the electronic component CH11. Similarly, the movable mechanisms 22B, 22C, 22D pressurize the electronic components CH12, CH21, CH22. By pressurizing the electronic components CH11, CH12, CH21, CH22, the bonding materials SN11, SN12, SN21, SN22 are pressurized. As shown in FIG. 4, the temperature of the workpieces W1, W2 at this time is approximately 250°C to 300°C, which is the sintering process temperature. The bonding materials SN11, SN12, SN21, SN22 are sintered by heating and pressurizing for a predetermined time. The sintered bonding material SN11 bonds the electronic component CH11 and the substrate SB1, the sintered bonding material SN12 bonds the electronic component CH12 and the substrate SB1, the sintered bonding material SN21 bonds the electronic component CH21 and the substrate SB2, and the sintered bonding material SN22 bonds the electronic component CH22 and the substrate SB2. That is, the electronic components CH11, CH12 are mounted on the substrate SB1, and the electronic components CH21, CH22 are mounted on the substrate SB2.

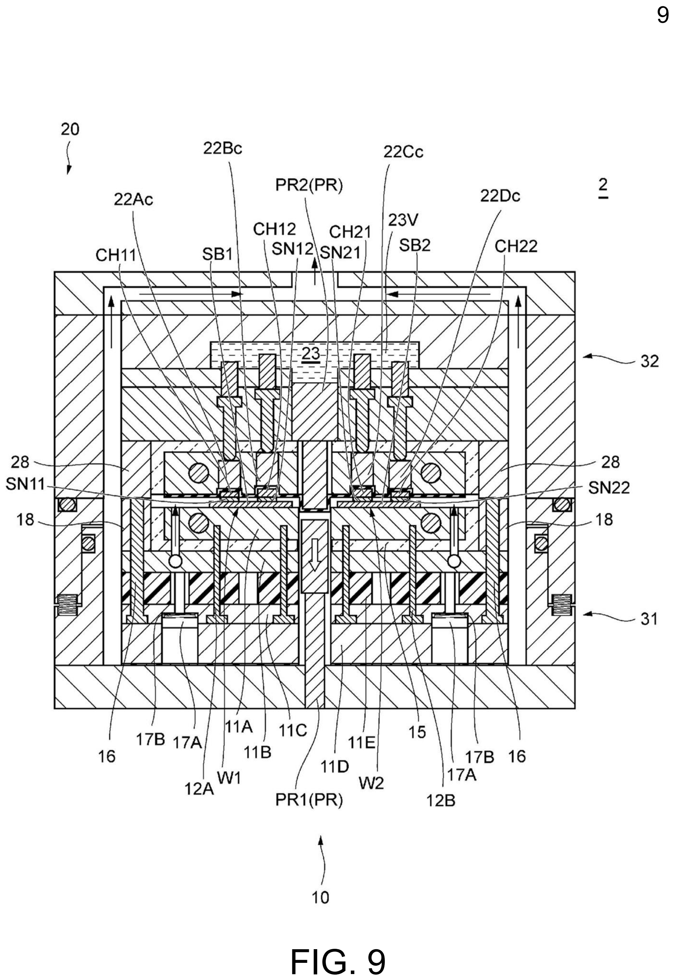

Next, the plunger PR is lowered (S23). As shown in FIG. 9, the lower plunger PR1 is pulled down. The tip end part of the lower plunger PR1 separates from the tip end part of the upper plunger PR2. The viscous member 23V is released from the pressing force by the plunger PR and pushes down the upper plunger PR2. As shown in FIG. 4, the temperature of the workpieces W1, W2 at this time is approximately 250°C to 300°C, which is the sintering process temperature. In this step, the abutment between the lower plunger PR1 and the upper plunger PR2 may be maintained, and the abutment between both plungers may be released in the mold opening step described later.

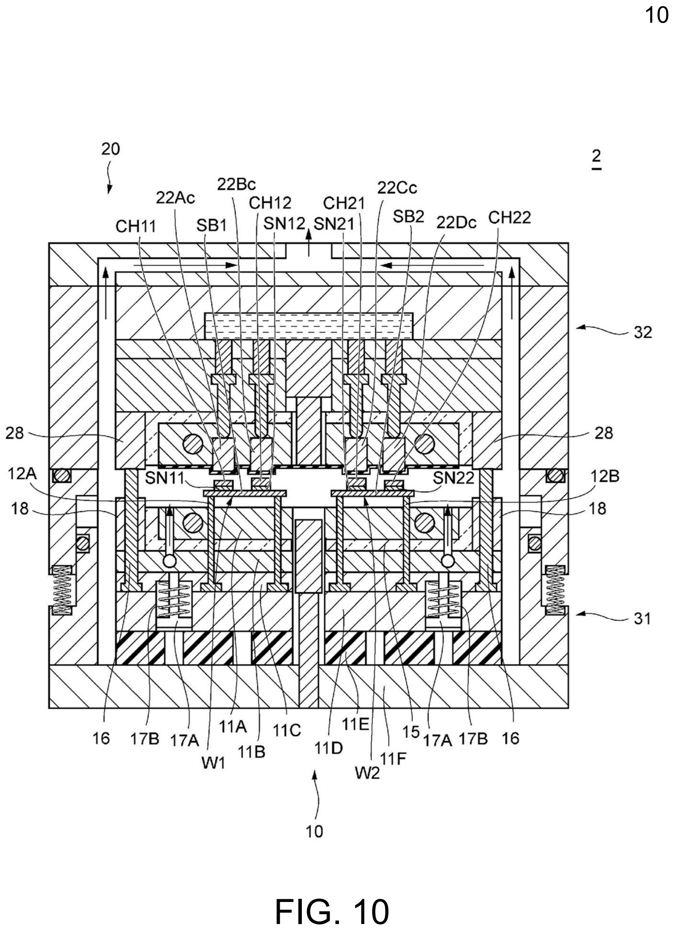

Next, mold opening is performed to raise the lifter pins 12A, 12B, and the substrates SB1, SB2 are separated from the cavity plate 11A of the lower mold 10 (S24). As shown in FIG. 10, the side block 28 of the upper mold 20 is separated from the side block 18 of the lower mold 10. The spring 17B exerts an elastic force in a direction that causes the ejector pin plate 11C to approach the lower mold chase 11B to which the base end part of the spring sleeve 17A (the side where the shoulder bolt is screwed, the upper side) is screwed. Since the position of the lower mold chase 11B is fixed by the support pillar 11E, the ejector pin plate 11C and the retainer plate 11D connected to the ejector pin plate 11C are pushed upward. As a result, the ejector pin plate 11C and the retainer plate 11D are raised, and the lifter pins 12A, 12B whose base end parts are sandwiched between the ejector pin plate 11C and the retainer plate 11D are also raised. The tip end parts of the lifter pins 12A, 12B protrude from the cavity plate 11A and abut against the substrates SB1, SB2, and the workpieces W1, W2 are separated from the cavity plate 11A. The gas supply port 13 supplies nitrogen gas toward the workpieces W1, W2. The workpieces W1, W2 are cooled by being separated from the cavity plate 11A, which is the heat source, and by receiving the supply of nitrogen gas. As shown in FIG. 4, the temperature of the workpieces W1, W2 at this time is approximately 250°C to 300°C, which is the sintering process temperature.

Next, the supply of nitrogen gas is stopped, and degassing is stopped (S25). As shown in FIG. 4, at the stage when the workpieces W1, W2 have been cooled to approximately 100°C to 150°C, as shown in FIG. 10, after the supply of nitrogen gas from the gas supply port 13 is stopped, degassing from the degassing port 29 is stopped. As a result, cooling of the workpieces W1, W2 within the mounting device 1 ends.

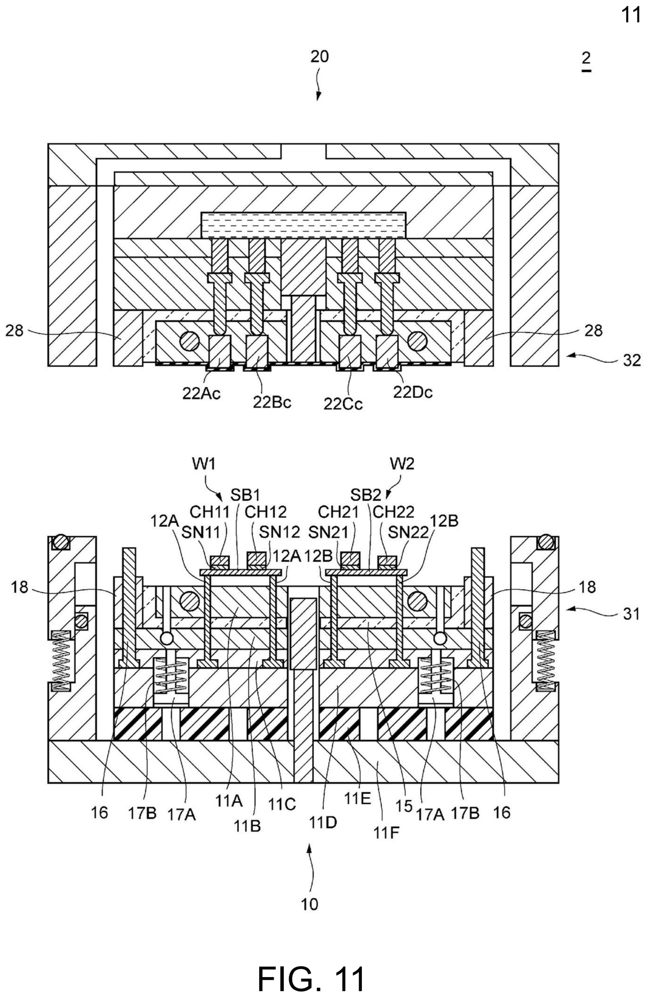

Finally, the mold is further opened, the degassing chambers 31, 32 are opened, and the workpieces W1, W2 are taken out (S26). As shown in FIG. 11, the degassing chamber 31 and the degassing chamber 32 are separated, and the workpieces W1, W2 are released. The workpieces W1, W2 are recovered from above the lifter pins 12A, 12B.

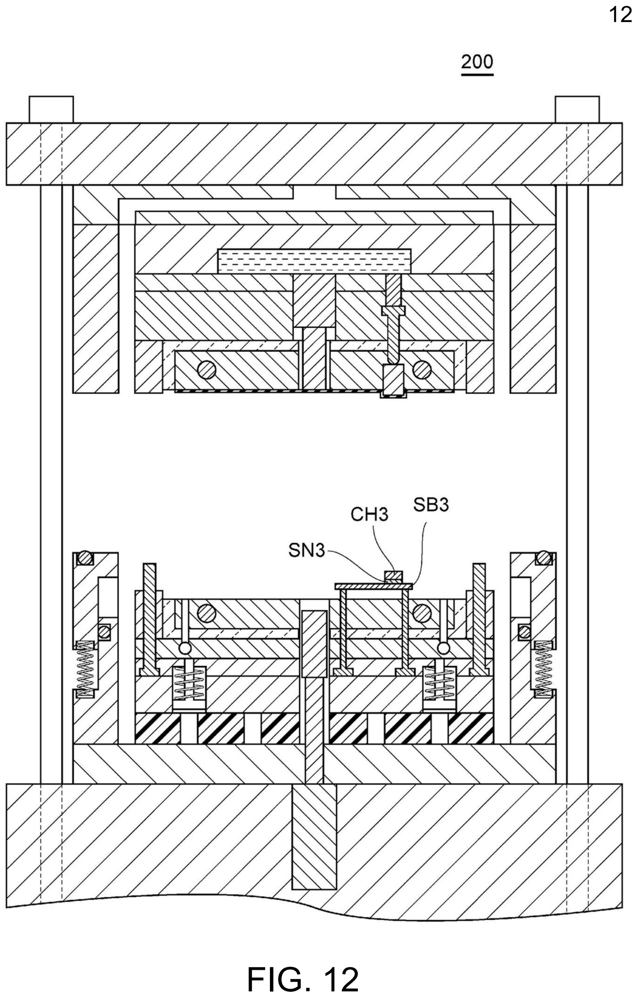

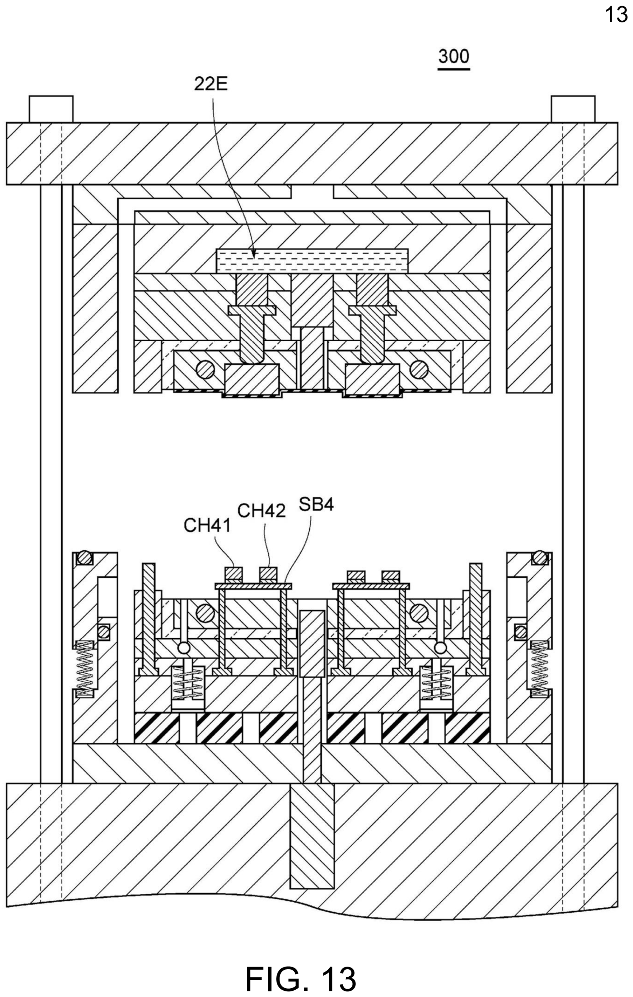

Next, with reference to FIG. 12 and FIG. 13, the configuration of a modification example of the mounting device according to an embodiment of the invention is described. FIG. 12 and FIG. 13 are diagrams showing an overall summary of the mounting device according to one modification example of the invention. The same or similar reference numerals are assigned to the same or similar configurations, and descriptions thereof are omitted as appropriate. In addition, similar operational effects due to similar configurations are not mentioned each time.

The mounting device 200 shown in FIG. 12 mounts one electronic component CH3 onto one substrate SB3 via one bonding material SN3. The mounting device 300 shown in FIG. 13 mounts multiple electronic components CH41, CH42 onto one substrate SB4 by one movable mechanism 22E. The movable mechanism 22E pressurizes the multiple electronic components CH41, CH42 simultaneously. According to the mounting device 300, even in a case where the spacing between the electronic component CH41 and the electronic component CH42 is narrow and it is difficult to provide multiple movable mechanisms that individually pressurize the multiple electronic components CH41, CH42, the electronic components CH41, CH42 can be pressurized simultaneously. The tip surface of the movable piece of the movable mechanism 22E may be provided with unevenness corresponding to the heights of the electronic components CH41, CH42. According to this, in the case where the height of the electronic component CH41 and the height of the electronic component CH42 are different, the difference in pressure applied to the respective electronic components CH41, CH42 by the movable mechanism 22E can be reduced. In addition, the tip surface of the movable piece of the movable mechanism 22E may be provided with an elastic material. According to this, in the case where the height of the electronic component CH41 and the height of the electronic component CH42 are different, the tip surface of the movable piece deforms according to the heights of the electronic components CH41, CH42, so that the difference in pressure applied to the respective electronic components CH41, CH42 by the movable mechanism 22E can be reduced.

As described above, the mounting device according to an embodiment of the invention is not limited to a configuration that mounts electronic components onto one substrate, and may be any configuration that mounts one or more electronic components onto at least one substrate. In addition, the mounting device according to an embodiment of the invention is not limited to a configuration that pressurizes multiple electronic components with a corresponding number of movable mechanisms, and may be any configuration that pressurizes multiple electronic components with at least one movable mechanism.

Hereinafter, a part or all of the embodiments of the invention are additionally described. The invention is not limited to the following additional descriptions.

### [Appendix 1]

A mounting device for mounting one or more electronic components on at least one substrate includes: a first mold, configured to hold the substrate; a second mold, disposed opposite to the first mold, and having at least one movable mechanism connected to an internal space of the second mold; and a pressure transmission mechanism, pressing a viscous member enclosed in the internal space of the second mold. In a state where the molds are closed, the mounting device pressurizes the electronic component by the movable mechanism via the viscous member based on a pressing force with which the pressure transmission mechanism presses the viscous member.

According to the embodiment, by pressing the viscous member enclosed in the internal space of the second mold with the pressure transmission mechanism, the internal pressure of the internal space of the second mold changes. The at least one movable mechanism moves based on the internal pressure of the internal space of the second mold and pressurizes one or more electronic components. Therefore, by adjusting the pressing force of the pressure transmission mechanism, the pressure that the at least one movable mechanism applies to one or more electronic components can be adjusted. Accordingly, the occurrence of mounting defects resulting from an excessive or insufficient pressure applied to the electronic components can be suppressed. For example, even when the heights of the electronic components or the thicknesses of the substrates vary, appropriate pressures can be applied to the electronic components. In addition, the viscous member that moves the movable mechanism is enclosed in the internal space of the second mold, and does not flow in from outside the second mold, nor does it flow out to outside the second mold. Therefore, compared to a mounting device that moves the movable mechanism via a fluid supplied from outside the second mold, miniaturization can be achieved.

### [Appendix 2]

In the mounting device according to [Appendix 1], the pressure transmission mechanism includes: a first pressure transmission part, provided in the first mold; and a second pressure transmission part, provided in the second mold and connected to the internal space of the second mold. The second pressure transmission part is pressed by the first pressure transmission part to press the viscous member.

According to the embodiment, as the second mold, a mold and a press device used for transfer molding can be utilized.

### [Appendix 3]

In the mounting device according to [Appendix 1] or [Appendix 2], the one or more electronic components are multiple electronic components including: a first electronic component; and a second electronic component adjacent to the first electronic component, the at least one movable mechanism is multiple movable mechanisms including a first movable mechanism and a second movable mechanism, and in the state where the first mold and the second mold are closed, based on the pressing force with which the pressure transmission mechanism presses the viscous member, the first electronic component is pressurized by the first movable mechanism via the viscous member, and the second electronic component is pressurized by the second movable mechanism, and the electronic components are mounted on one substrate.

According to the embodiment, since the first movable mechanism and the second movable mechanism move based on the internal pressure of the internal space of the second mold, the pressure that the first movable mechanism and the second movable mechanism apply to the first electronic component and the second electronic component does not depend on the positions of the first movable mechanism and the second movable mechanism. That is, even if the positions of the first movable mechanism and the second movable mechanism differ from each other, the first movable mechanism and the second movable mechanism receive the substantially equal internal pressure of the internal space, and simultaneously pressurize the first electronic component and the second electronic component based on the received internal pressure of the internal space. Therefore, the difference between the pressure applied to the first electronic component and the pressure applied to the second electronic component can be reduced. For example, even in the case where the heights of the first electronic component and the second electronic component differ, or in the case where the thickness of the substrate varies depending on the positions of the first electronic component and the second electronic component, the first electronic component and the second electronic component can be simultaneously pressurized with substantially equal pressures.

### [Appendix 4]

In the mounting device according to [Appendix 1] or [Appendix 2], the one or more electronic components are multiple electronic components including a first electronic component and a second electronic component adjacent to the first electronic component, the at least one movable mechanism is multiple movable mechanisms including a first movable mechanism, in the state where the first mold and the second mold are closed, based on the pressing force with which the pressure transmission mechanism presses the viscous member, the first electronic component and the second electronic component are pressurized by the first movable mechanism via the viscous member, and the electronic components are mounted on one substrate.

According to the embodiment, even if the spacing between the first electronic component and the second electronic component is narrow, the first electronic component and the second electronic component can be mounted simultaneously.

### [Appendix 5]

In the mounting device according to any one of [Appendix 1] to [Appendix 4], the viscous member is silicone oil.

### [Appendix 6]

In the mounting device according to any one of [Appendix 1] to [Appendix 5], the at least one movable mechanism includes: at least one piston, connected to the internal space of the second mold and movable by receiving an internal pressure of the internal space; and at least one movable piece, applying a pressure transmitted from the at least one piston to the one or more electronic components, and the second mold further includes: a heater, heating the at least one movable piece; and a heat insulation member, partitioning the heater and the internal space.

According to the embodiment, when the heater heats the at least one movable piece, a temperature rise of the viscous member can be suppressed. Therefore, the property change and the thermal degradation of the viscous member can be suppressed.

### [Appendix 7]

In the mounting device according to any one of [Appendix 1] to [Appendix 6], at least one of the first mold and the second mold has a gas supply port that supplies inert gas toward the one or more electronic components and the at least one substrate.

According to the embodiment, at the time of heating the one or more electronic components and the at least one substrate, the oxidizing gas can be rapidly removed from the surroundings of the one or more electronic components and the at least one substrate to create an inert gas atmosphere. Therefore, bonding defects due to oxidation of the bonding material can be suppressed. In addition, at the time of cooling the one or more electronic components and the at least one substrate, gas cooling can be performed by directing inert gas toward the one or more electronic components and the at least one substrate. Since the cooling rate of the mounted product is improved, the time required to remove the mounted product from the mounting device is shortened, and production efficiency can be improved.

### [Appendix 8]

The mounting device according to any one of [Appendix 1] to [Appendix 7] further includes a degassing chamber that is openable and closable and surrounds the first mold and the second mold.

According to the embodiment, the one or more electronic components and the at least one substrate can be placed in a vacuum atmosphere or an inert gas atmosphere, so that oxidation can be suppressed. Therefore, the one or more electronic components and the at least one substrate can be heated to a high temperature.

### [Appendix 9]

In the mounting device according to any one of [Appendix 1] to [Appendix 8], the first mold includes: a cavity plate, provided on a side opposing the second mold; and a holding part, configured to be able to advance and retract relative to the second mold from the cavity plate and holding the at least one substrate, in a state where the first mold and the second mold are opened, the holding part enters a space between the first mold and the second mold, and the at least one substrate supported by the holding part is separated from the cavity plate, and in the state where the first mold and the second mold are closed, the holding part retracts from the space between the first mold and the second mold, and the at least one substrate is supported in contact with the cavity plate.

### [Appendix 10]

In the mounting device according to any one of [Appendix 1] to [Appendix 9], at a time when a mounting process is performed, a film is stretched on a surface of the second mold opposing the first mold, and the movable mechanism contacts the electronic component at a tip end part via the film.

### [Appendix 11]

In the mounting device according to [Appendix 2], the first pressure transmission part includes one or multiple lower plungers, the second pressure transmission part includes upper plungers in a same quantity as that of the lower plungers, and the lower plungers and the upper plungers are disposed in opposing arrangement to form pairs.

### [Appendix 12]

In the mounting device according to any one of [Appendix 1] to [Appendix 11], the mounting device is a sintering device.

According to the embodiment, even in a sintering device where a high temperature and a high pressure are required, the difference between the pressure applied to the first electronic component and the pressure applied to the second electronic component can be reduced. Therefore, the occurrence of mounting defects can be suppressed.

### [Appendix 13]

A mounting method for mounting one or more electronic components on at least one substrate includes: preparing a first mold configured to hold the substrate on which the electronic component is placed; preparing a second mold disposed to oppose the first mold, the second mold having multiple movable mechanisms connected to an internal space of the second mold; and preparing a pressure transmission mechanism that presses a viscous member enclosed in the internal space of the second mold. The electronic components include a first electronic component and a second electronic component. The movable mechanisms include a first movable mechanism and a second movable mechanism. The mounting method further includes: closing the first mold and the second mold; pressing the viscous member by the pressure transmission mechanism; and in a state where the first mold and the second mold are closed, pressurizing the electronic component by the movable mechanism via the viscous member based on a pressing force with which the pressure transmission mechanism presses the viscous member.

According to the embodiment, by pressing the viscous member enclosed in the internal space of the second mold by the pressure transmission mechanism, the internal pressure of the internal space of the second mold changes. At least one movable mechanism moves based on the internal pressure of the internal space of the second mold and pressurizes one or more electronic components. Therefore, by adjusting the pressing force of the pressure transmission mechanism, the pressure that at least one movable mechanism applies to one or more electronic components can be adjusted. Accordingly, the occurrence of mounting defects caused by an excessive or insufficient pressure applied to the electronic components can be suppressed. For example, even when the heights of multiple electronic components or the thicknesses of multiple substrates vary, appropriate pressure can be applied to the electronic components. Furthermore, the viscous member that moves the movable mechanisms is enclosed in the internal space of the second mold, and does not flow in from outside the second mold, nor does it flow out to outside the second mold. Therefore, compared to a mounting device that moves the movable mechanisms via the fluid supplied from outside the second mold, miniaturization can be achieved.

As described above, a compact mounting device capable of suppressing the occurrence of mounting defects and a mounting method using the same can be provided.

The embodiments described above are intended to facilitate understanding of the invention and are not intended to limit the interpretation of the invention. Each element included in the embodiments, as well as the arrangements, materials, conditions, shapes, sizes, and the like, are not limited to those illustrated and can be changed as appropriate. Furthermore, configurations shown in different embodiments can be partially substituted or combined with each other.

### [Reference Signs List]

1...mounting device
10...lower mold
11A...cavity plate
11B...lower mold chase
11C...ejector pin plate
11D...retainer plate
11E...support pillar
11F...lower mold base
12A, 12B...lifter pin
13...gas supply port
14...heater
15...heat insulation member
16...set pin
17A...spring sleeve
17B...spring
18...side block
20...upper mold
21A...cavity plate
21B...upper mold chase
21C...lower support plate
21D...upper support plate
21E...upper mold base
22A, 22B, 22C, 22D...movable mechanism
22Aa, 22Ba, 22Ca, 22Da...piston
22Ab, 22Bb, 22Cb, 22Db...rod
22Ac, 22Bc, 22Cc, 22Dc...movable piece
23...internal space
23V...viscous member
24...heater
25...heat insulation member
27...degassing path
28...side block
29...degassing port
31,32...degassing chamber
33,34...degassing path
PR...plunger
PR1...lower plunger
PR2...upper plunger

## Claims

1. A mounting device for mounting one or more electronic components on at least one substrate, the mounting device comprising:
a first mold, configured to hold the substrate on which the electronic component is placed;
a second mold, disposed opposite to the first mold, and having at least one movable mechanism connected to an internal space of the second mold; and
a pressure transmission mechanism, pressing a viscous member enclosed in the internal space of the second mold,
wherein, in a state where the first mold and the second mold are closed, the electronic component is pressurized by the movable mechanism via the viscous member based on a pressing force with which the pressure transmission mechanism presses the viscous member.

2. The mounting device as claimed in claim 1, wherein:
the pressure transmission mechanism comprises:
a first pressure transmission part, provided in the first mold; and
a second pressure transmission part, provided in the second mold and connected to the internal space of the second mold,
wherein the second pressure transmission part is pressed by the first pressure transmission part to press the viscous member.

3. The mounting device as claimed in claim 1, wherein:
the one or more electronic components are a plurality of electronic components comprising: a first electronic component; and a second electronic component adjacent to the first electronic component,
the at least one movable mechanism is a plurality of movable mechanisms comprising a first movable mechanism and a second movable mechanism,
in the state where the first mold and the second mold are closed, based on the pressing force with which the pressure transmission mechanism presses the viscous member, the first electronic component is pressurized by the first movable mechanism via the viscous member, and the second electronic component is pressurized by the second movable mechanism, and
the electronic components are mounted on one substrate.

4. The mounting device as claimed in claim 1, wherein:
the one or more electronic components are a plurality of electronic components comprising a first electronic component and a second electronic component adjacent to the first electronic component,
the at least one movable mechanism is a plurality of movable mechanisms comprising a first movable mechanism,
in the state where the first mold and the second mold are closed, based on the pressing force with which the pressure transmission mechanism presses the viscous member, the first electronic component and the second electronic component are pressurized by the first movable mechanism via the viscous member, and
the electronic components are mounted on one substrate.

5. The mounting device as claimed in claim 1, wherein the viscous member is silicone oil.

6. The mounting device as claimed in claim 1, wherein:
the at least one movable mechanism comprises:
at least one piston, connected to the internal space of the second mold and movable by receiving an internal pressure of the internal space; and
at least one movable piece, applying a pressure transmitted from the at least one piston to the one or more electronic components, and
the second mold further comprises:
a heater, heating the at least one movable piece; and
a heat insulation member, partitioning the heater and the internal space.

7. The mounting device as claimed in claim 1, wherein:
at least one of the first mold and the second mold has a gas supply port that supplies inert gas toward the one or more electronic components and the at least one substrate.

8. The mounting device as claimed in claim 1, further comprising a degassing chamber that is openable and closable and surrounds the first mold and the second mold.

9. The mounting device as claimed in claim 1, wherein:
the first mold comprises:
a cavity plate, provided on a side opposing the second mold; and
a holding part, configured to be able to advance and retract relative to the second mold from the cavity plate, and holding the at least one substrate,
in a state where the first mold and the second mold are opened, the holding part enters a space between the first mold and the second mold, and the at least one substrate supported by the holding part is separated from the cavity plate, and
in the state where the first mold and the second mold are closed, the holding part retracts from the space between the first mold and the second mold, and the at least one substrate is supported in contact with the cavity plate.

10. The mounting device as claimed in claim 1, wherein:
at a time when a mounting process is performed, a film is stretched on a surface of the second mold opposing the first mold, and
the movable mechanism contacts the electronic component at a tip end part via the film.

11. The mounting device as claimed in claim 2, wherein:
the first pressure transmission part comprises one or a plurality of lower plungers,
the second pressure transmission part comprises upper plungers in a same quantity as that of the lower plungers, and
the lower plungers and the upper plungers are disposed in opposing arrangement to form pairs.

12. The mounting device as claimed in any one of claims 1 to 11, wherein the mounting device is a sintering device.

13. A mounting method for mounting one or more electronic components on at least one substrate, the mounting method comprising:
preparing a first mold configured to hold the substrate on which the electronic component is placed;
preparing a second mold disposed to oppose the first mold, wherein the second mold has at least one movable mechanism connected to an internal space of the second mold; and
preparing a pressure transmission mechanism that presses a viscous member enclosed in the internal space of the second mold,
wherein the mounting method further comprises:
closing the first mold and the second mold;
pressing the viscous member by the pressure transmission mechanism; and
in a state where the first mold and the second mold are closed, pressurizing the electronic component by the movable mechanism via the viscous member based on a pressing force with which the pressure transmission mechanism presses the viscous member.
